# EUROPEAN PATENT APPLICATION

(11) **EP 2 993 482 A1**
(43) Date of publication of application: **09.03.2016**
(21) Application number: 14275180.9
(22) Date of filing: 02.09.2014
(51) Int. Cl.: G01R 31/333, H02M 7/483

(54) **Synthetic test circuit**

(71) Applicant: ALSTOM Technology Ltd, 5400 Baden (CH)
(72) Inventor: Trainer, David Reginald, Derby DE24 0AQ (GB); Dang, Si, Stafford ST16 2EB (GB); Moreno Muñoz, Francisco Jose, Stafford ST16 2QZ (GB)
(74) Representative: Potter Clarkson LLP

(57) **Abstract**

A synthetic test circuit (30), for performing an electrical test on a device (52) under test, comprises:
a terminal (32,34) connectable to the device (52) under test;
a voltage injection circuit (40) operably connected to the terminal (32,34), the voltage injection circuit (40) including a first voltage source (46a), the first voltage source (46a) including a chain-link converter, the chain-link converter including a plurality of modules, each module including at least one energy storage device; and
a controller (50) being configured to operate each module of the voltage injection circuit (40) to selectively bypass the or each corresponding energy storage device and insert the or each corresponding energy storage device into the chain-link converter so as to generate a voltage across the chain-link converter and thereby operate the voltage injection circuit (40) to inject a voltage waveform into the device under test,
wherein the voltage injection circuit (40) further includes a second voltage source (46a), the second voltage source (46a) being or including a capacitive energy storage device (54), the capacitive energy storage device (54) being fixedly connected in circuit in the voltage injection circuit (40).

## Description

This invention relates to a synthetic test circuit for performing an electrical test on a device under test, in particular a synthetic test circuit for performing an electrical test on a thyristor valve for use in high voltage direct current (HVDC) power transmission.

It is known to employ a synthetic test circuit to test a thyristor valve that is for use in HVDC power transmission. The term "synthetic" is used to describe the test circuit because the test circuit does not form part of an actual HVDC station converter, i.e. the thyristor valve under test is not connected into the actual HVDC station converter which transfers significant real power.

According to an aspect of the invention, there is provided a synthetic test circuit, for performing an electrical test on a device under test, comprising:
a terminal connectable to the device under test;
a voltage injection circuit operably connected to the terminal, the voltage injection circuit including a first voltage source, the first voltage source including a chain-link converter, the chain-link converter including a plurality of modules, each module including at least one energy storage device; and
a controller being configured to operate each module of the voltage injection circuit to selectively bypass the or each corresponding energy storage device and insert the or each corresponding energy storage device into the chain-link converter so as to generate a voltage across the chain-link converter and thereby operate the voltage injection circuit to inject a voltage waveform into the device under test,
wherein the voltage injection circuit further includes a second voltage source, the second voltage source being or including a capacitive energy storage device, the capacitive energy storage device being fixedly connected in circuit in the voltage injection circuit.

The structure of the chain-link converter (which may, for example, comprise a plurality of series-connected modules) permits build-up of a combined voltage across the chain-link converter, which is higher than the voltage available from each of its individual modules, via the insertion of the energy storage devices of multiple modules, each providing its own voltage, into the chain-link converter. In this manner the chain-link converter is capable of providing a stepped variable voltage source, which permits the generation of a voltage waveform across the chain-link converter using a step-wise approximation. As such the chain-link converter is capable of providing complex voltage waveforms to enable the voltage injection circuit to inject a wide range of voltage waveforms into the device under test, and so enables the synthetic test circuit to readily and reliably create test voltage conditions that are identical or closely similar to actual in-service voltage conditions.

In addition the capability of the chain-link converter to generate a voltage waveform thereacross using a step-wise approximation allows the voltage injection circuit to inject voltage waveforms of varying levels into the device under test, and thus renders the synthetic test circuit capable of electrically testing various devices across a wide range of device ratings.

Furthermore the modular arrangement of the chain-link converter means that the number of modules in the chain-link converter can be readily scaled up or down to modify the voltage capability of the chain-link converter to match the testing requirements of the device under test, without having to make significant changes to the overall design of the synthetic test circuit.

The provision of the chain-link converter in the voltage injection circuit therefore results in a synthetic test circuit that is not only capable of performing high quality electrical testing, but also has the flexibility to perform an electrical test on a broad range of devices with different device ratings.

It will be understood that the fixed connection of the capacitive energy storage device in circuit in the voltage injection circuit is intended to mean that the capacitive energy storage device stays electrically connected within the voltage injection circuit and thereby is not switchable out of circuit with the rest of the voltage injection circuit, unlike the or each energy storage device of each module that is switchable into and out of circuit with the rest of the voltage injection circuit.

The provision of the capacitive energy storage device fixedly connected in circuit in the voltage injection circuit therefore allows the capacitive energy storage device to contribute to the injected voltage waveform without requiring any switching of the capacitive energy storage device into and out of circuit with the voltage injection circuit, thus reducing the number of modules in the corresponding chain-link converter necessary to enable injection of a given voltage waveform into the device under test.

The manner in which the second voltage source is connected in the voltage injection circuit may vary, so long as the capacitive energy storage device is fixedly connected in circuit in the voltage injection circuit. For example, the second voltage source may be fixedly connected in series with the chain-link converter of the voltage injection circuit.

In embodiments of the invention, each module may include at least one module switch. In such embodiments, the controller may be configured to control switching of the or each module switch of each module of the voltage injection circuit so as to block current from flowing in each module and thereby inhibit current from flowing in the voltage injection circuit.

For example, the or each module switch of each module may include an active switching device (such as an IGBT) connected in parallel with an anti-parallel passive current check element, and the controller may be configured to turn off the or each active switching device of each module of the voltage injection circuit to allow the anti-parallel passive current check elements to form a plurality of series-connected passive current check element rectifiers with a combined internal voltage that is greater than a voltage across the second voltage source so as to block current from flowing in each module and thereby inhibit current from flowing in the voltage injection circuit, wherein the combined internal voltage is provided by the energy storage devices of the modules.

In this manner the voltage injection circuit can be controlled to block current from flowing therethrough when the associated electrical test requires such blocking of current flow.

For the purposes of this specification, a current check element is a device that permits current to flow therethrough in only one direction, e.g. a diode.

During injection of the voltage waveform into the device under test, the capacitive energy storage device of the second voltage source may discharge, thus resulting in a change in its voltage contribution to the injected voltage waveform.

In further embodiments of the invention, the controller may be configured to operate each module of the voltage injection circuit to selectively bypass the or each corresponding energy storage device and insert the or each corresponding energy storage device into the chain-link converter so as to vary a voltage across the chain-link converter during discharging of the capacitive energy storage device of the second voltage source. This not only permits dynamic control over the voltage of the voltage injection circuit, but also improves control over the discharge rate of the capacitive energy storage device.

The structure of each voltage source may vary to meet the testing requirements of the device under test.

The first voltage source may be a bidirectional voltage source and/or the second voltage source may be a bidirectional voltage source.

Each energy storage device may be arranged in the respective module so as to be insertable in the chain-link converter to provide a bidirectional voltage source. This enables the chain-link converter to generate a bidirectional voltage waveform thereacross.

Each module includes a plurality of module switches connected with the or each energy storage device to define a bipolar module that can provide negative, zero or positive voltages

Each module may include a plurality of module switches connected in parallel with an energy storage device in a full-bridge arrangement to define a bipolar module that can provide negative, zero or positive voltages.

Each module may include a plurality of module switches connected in parallel with an energy storage device in a full-bridge arrangement to define:
a 4-quadrant bipolar module that can provide negative, zero or positive voltages and can conduct current in two directions; or
a bipolar module that can provide negative, zero or positive voltages and can conduct current in only one direction.

The synthetic test circuit may be rated for performing an electrical test on a switching element. The switching element is preferably a thyristor valve and further preferably a thyristor valve for use in high voltage direct current (HVDC) power transmission.

In order to be certified for service operation, a switching element must comply with various testing requirements.

The controller is configured to operate each module of the voltage injection circuit to selectively bypass the or each corresponding energy storage device and insert the or each corresponding energy storage device into the chain-link converter so as to generate a voltage across the chain-link converter and thereby inject a current waveform into the switching element so as to control a turn-off rate of change of current in the switching element. This allows the voltage injection circuit to readily impose a desired rate of change of current in the switching element during its turn-off, in accordance with associated testing requirements.

The controller may be configured to operate the voltage injection circuit to inject a voltage waveform into the switching element to carry out an electrical test selected from a group including:
- application of a turn-off recovery voltage transient and/or overshoot to the switching element;
- application of a turn-on or turn-off rate of change of voltage to the switching element;
- application of an off-state voltage stress to the switching element;
- application of a turn-on voltage transient to the switching element.
The synthetic test circuit may further include a current injection circuit operably connected to the terminal, the current injection circuit including a current source, the current source including a chain-link converter, the chain-link converter including a plurality of modules, each module including at least one energy storage device,
wherein the controller is configured to operate each module of the current injection circuit to selectively bypass the or each corresponding energy storage device and insert the or each corresponding energy storage device into the chain-link converter so as to generate a voltage across the chain-link converter and thereby operate the current injection circuit to inject a current waveform into the device under test.

In a similar fashion to that of the voltage injection circuit, the structure of the chain-link converter enables the current injection circuit to inject a wide range of current waveforms into the device under test, and so enables the synthetic test circuit to readily and reliably create test current conditions that are identical or closely similar to actual in-service current conditions.

The voltage injection circuit may include an inductor operatively connected to the first and second voltage sources. The inclusion of the inductor in the voltage injection circuit provides a current control element for improving control over the injection of a current waveform into the device under test.

The controller may be configured to operate each module of the voltage injection circuit to selectively bypass the or each corresponding energy storage device and insert the or each corresponding energy storage device into the chain-link converter so as to generate a voltage across the chain-link converter and thereby apply a voltage across the inductor in order to control the current waveform injected into the switching element so as to control a turn-off rate of change of current in the switching element.

Preferred embodiments of the invention will now be described, by way of non-limiting examples, with reference to the accompanying drawings in which:
Figure 1 shows schematically a synthetic test circuit according to a first embodiment of the invention;
Figure 2 shows schematically current and voltage injection circuits of the synthetic test circuit of Figure 1;
Figures 3 and 4 illustrate the basic operations of the current and voltage injection circuits of Figure 2;
Figure 5 illustrates the operation of the voltage injection circuit of Figure 1 to inject voltage and current waveforms into a thyristor valve under test;
Figures 6 to 9 illustrate a use of the synthetic test circuit of Figure 1 to perform an electrical test on a thyristor valve under test; and
Figures 10 and 11 show results of a simulation model for the synthetic test circuit of Figure 1.

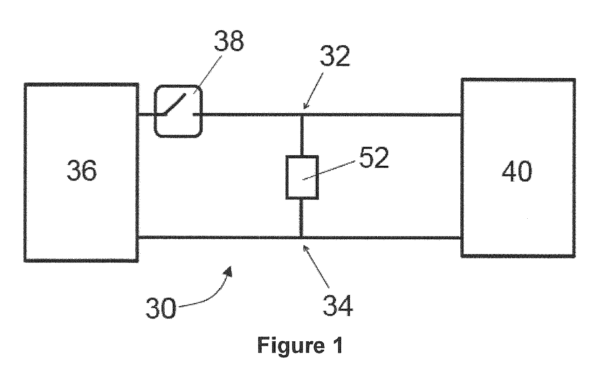

A synthetic test circuit according to a first embodiment of the invention is shown in Figure 1 and is designated generally by the reference numeral 30.

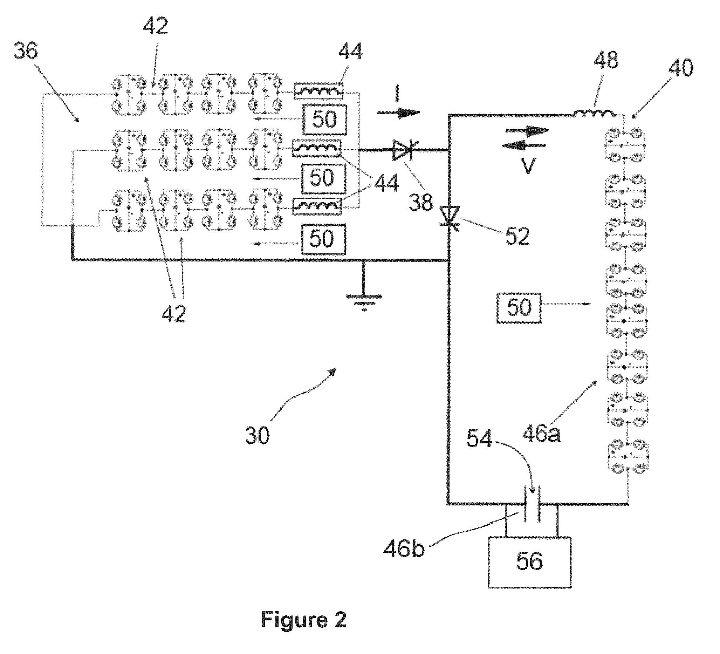

The synthetic test circuit 30 comprises first and second terminals 32,34, a current injection circuit 36, an isolation switch 38 and a voltage injection circuit 40. As shown in Figure 2, the current injection circuit 36 is connected in series with the isolation switch 38 between the first and second terminals 32,34, and the voltage injection circuit 40 is connected between the first and second terminals 32,34, and is thereby connected in parallel with the series connection of the current injection circuit 36 and isolation switch 38.

The current injection circuit 36 includes a plurality of parallel-connected current sources 42, each of which includes a series-connection of a chain-link converter and an inductor 44.

Each chain-link converter includes a plurality of series-connected modules. Each module includes two pairs of module switches and an energy storage device in the form of a capacitor. In each module, the pairs of module switches are connected in parallel with the capacitor in a full-bridge arrangement to define a 4-quadrant bipolar module that can provide negative, zero or positive voltages and can conduct current in two directions.

Each module switch constitutes an insulated gate bipolar transistor (IGBT) that is connected in anti-parallel with a diode. It is envisaged that, in other embodiments of the invention, each IGBT may be replaced by a gate turn-off thyristor, a field effect transistor, an injection-enhanced gate transistor, an integrated gate commutated thyristor or any other self-commutated switching device.

It is envisaged that, in other embodiments of the invention, each capacitor in each module may be replaced by another type of energy storage device that is capable of storing and releasing energy, e.g. a battery or fuel cell.

The capacitor of each module is selectively bypassed or inserted into the respective chain-link converter by changing the states of the corresponding module switches. This selectively directs current through the capacitor or causes current to bypass the capacitor so that the module provides a negative, zero or positive voltage.

The capacitor of the module is bypassed when the module switches are configured to form a current path that causes current in the respective chain-link converter to bypass the capacitor, and so the module provides a zero voltage, i.e. the module is configured in a bypassed mode.

The capacitor of the module is inserted into the respective chain-link converter when the module switches are configured to allow the current in the respective chain-link converter to flow into and out of the capacitor. The capacitor then charges or discharges its stored energy so as to provide a non-zero voltage, i.e. the module is configured in a non-bypassed mode. The full-bridge arrangement of the module switches permits configuration of the module switches to cause current to flow into and out of the capacitor in either direction, and so each module can be configured to provide a negative or positive voltage in the non-bypassed mode.

The structure of each chain-link converter permits build-up of a combined voltage across each chain-link converter, which is higher than the voltage available from each of its individual modules, via the insertion of the capacitors of multiple modules, each providing its own voltage, into each chain-link converter. In this manner each chain-link converter is capable of providing a stepped variable voltage source, which permits the generation of a voltage waveform across each chain-link converter using a step-wise approximation. As such each chain-link converter is capable of providing complex voltage waveforms.

The voltage injection circuit 40 includes series-connected first and second voltage sources 46a,46b.

The first voltage source 46a includes a chain-link converter, the structure and operation of which is identical to that of the chain-link converter of each current source 42 of the current injection circuit 36. The voltage source converter further includes an inductor 48 connected in series with the first and second voltage sources 46a,46b.

The second voltage source includes a capacitor 54 that is fixedly connected in circuit in the voltage injection circuit 40. In other words, the capacitor 54 stays electrically connected within the voltage injection circuit 40 and thereby is not switchable out of circuit with the rest of the voltage injection circuit 40, unlike the capacitor of each module that is switchable into and out of circuit with the rest of the voltage injection circuit 40. The capacitor 54 of the second voltage source 46b is fixedly connected in series with the chain-link converter of the voltage injection circuit 40. The capacitor 54 of the second voltage source 46b is referred to hereon as the "fixed capacitor" to distinguish the capacitor 54 of the second voltage source 46b from each capacitor of the first voltage source 46a.

The synthetic test circuit 30 further includes an optional power charging circuit 56 for charging the fixed capacitor 54 to a desired voltage level.

It is envisaged that, in other embodiments of the invention, each of the current and voltage injection circuits may include a different number and/or arrangement of chain-link converters.

A controller 50 is configured to control switching of the module switches of each module to selectively bypass the corresponding capacitor and insert the corresponding capacitor into the corresponding chain-link converter so as to generate a voltage across the corresponding chain-link converter.

The controller 50 is further configured to control switching of the isolation switch 38 to switch the current injection circuit 36 into and out of circuit with the first and second terminals 32,34 so as to selectively isolate the current injection circuit 36 from the device under test and the voltage injection circuit 40. The provision of the isolation switch 38 permits the current injection circuit 36 to be configured as a low voltage, high current injection circuit 36, and the voltage injection circuit 40 to be configured as a low current, high voltage injection circuit 40.

In use a device under test, namely a switching element in the form of a thyristor valve 52 that is for use in HVDC power transmission, is connected between the first and second terminals 32,34.

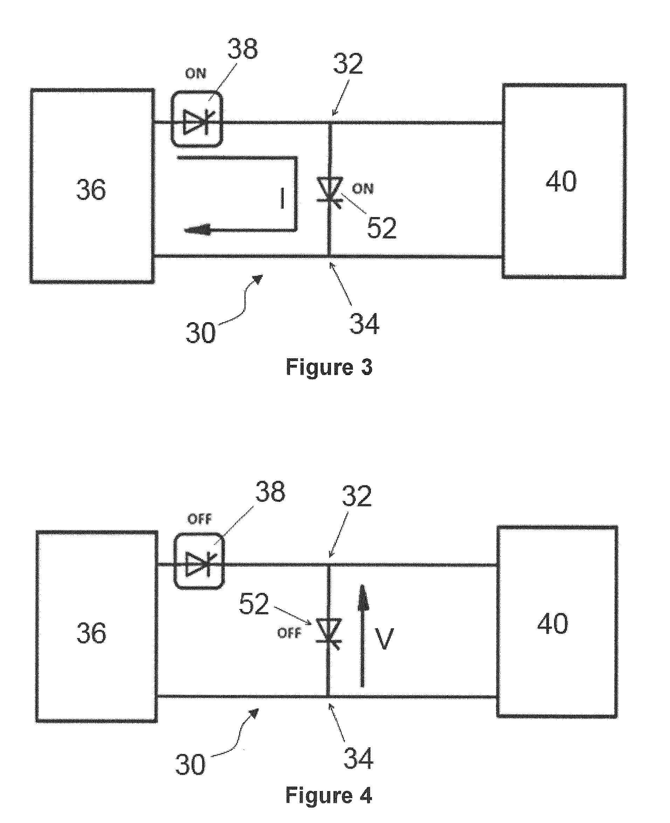

The configuration of the synthetic test circuit 30 as set out above enables the current injection circuit 36 to be operated to inject a current waveform I into the thyristor valve 52 under test, as shown in Figure 3, and enables the voltage injection circuit 40 to be operated to inject a voltage waveform V into the thyristor valve 52 under test, as shown in Figure 4. A cycle of such injections of current and voltage waveforms may be repeated at a desired frequency (e.g. 50 Hz).

Preferably, the isolation switch 38 is closed when the current injection circuit 36 is operated to inject a current waveform I into the thyristor valve 52 under test, and the isolation switch 38 is opened when the voltage injection circuit 40 is operated to inject a voltage waveform V into the thyristor valve 52 under test. This means that the synthetic test circuit 30 would not be required to supply high voltage and high current at the same time, thus minimising the amount of power used during electrical testing of the thyristor valve 52.

It will be appreciated that the number of parallel-connected current sources 42 in the current injection circuit 36 may vary to adapt the current capability of the current injection circuit 36 for compatibility with the current rating and test current conditions of the thyristor valve 52 under test. This is particularly useful due to the mismatch in current carrying capability between the IGBTs and the thyristor valve 52.

The thyristor valve 52 experiences a complex, varying set of actual in-service current and voltage conditions during its use in a power converter.

The capability of the chain-link converter to provide complex voltage waveforms thereacross enables the current and voltage injection circuits 36,40 to inject a wide range of current and voltage waveforms into the device under test, and so enables the synthetic test circuit 30 to readily and reliably create test current and voltage conditions that are identical or closely similar to the above actual in-service current and voltage conditions. The actual in-service current conditions for the thyristor valve 52 includes a current waveform with positive and negative rates of change of current. The controller 50 is able to operate each module of the current injection circuit 36 to selectively bypass the corresponding capacitor and insert the corresponding capacitor into the corresponding chain-link converter so as to generate a positive voltage across the corresponding chain-link converter and thereby operate the current injection circuit 36 to inject a current waveform with a positive rate of change of current into the thyristor valve 52 under test, and to generate a negative voltage across the corresponding chain-link converter and thereby operate the current injection circuit 36 to inject a current waveform with a negative rate of change of current into the thyristor valve 52 under test, in orderto create test current conditions that are identical or closely similar to the actual in-service current conditions.

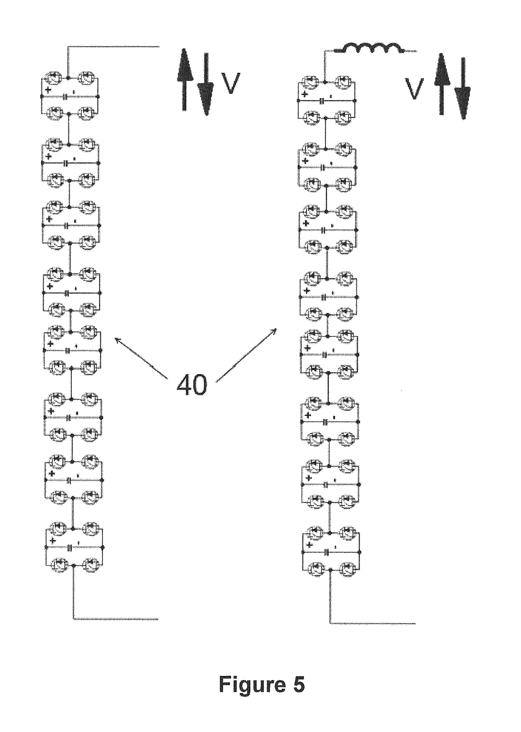

The actual in-service voltage conditions for the thyristor valve 52 includes a bidirectional voltage waveform. The controller 50 is able to operate each module of the voltage injection circuit 40 to selectively bypass the corresponding capacitor and insert the corresponding capacitor into the corresponding chain-link converter so as to generate a bidirectional voltage across the chain-link converter and thereby operate the voltage injection circuit 40 to inject a bidirectional voltage waveform V into the thyristor valve 52 under test, as shown in Figure 5, in order to create test voltage conditions that are identical or closely similar to the actual in-service voltage conditions.

In addition, as shown in Figure 5, the controller 50 is able to operate each module of the voltage injection circuit 40 to selectively bypass the corresponding capacitor and insert the corresponding capacitor into the chain-link converter so as to generate a bidirectional voltage across the chain-link converter, thus modifying the voltage across the inductor 44, and thereby operate the voltage injection circuit 40 to inject a current waveform into the thyristor valve 52 under test.

Typically a thyristor valve 52 that is for use in HVDC power transmission must comply with various testing requirements in order to be certified for service operation.

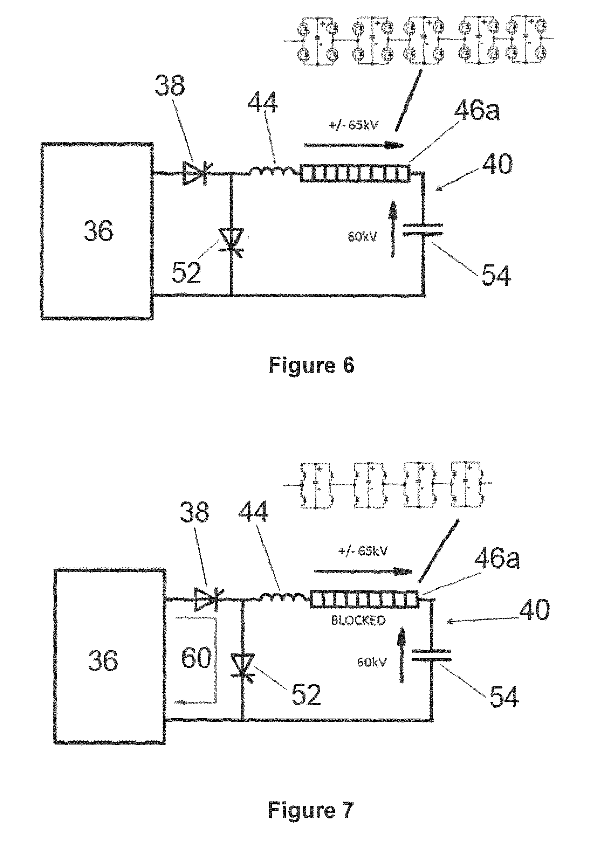

Use of the synthetic test circuit 30 to perform an electrical test, in the form of a resonant cycle, on the thyristor valve 52 under test is described as follows, with reference to Figures 6 to 9.

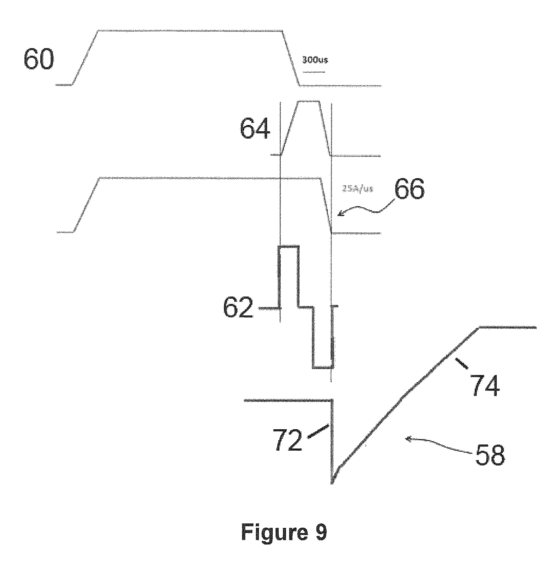

A thyristor valve 52 during its turn-off experiences a recovery voltage overshoot in the form of a negative recovery voltage transient (as indicated by reference numeral 58 in Figure 9).

The resonant cycle starts with the fixed capacitor 54 having been charged in its positive voltage direction to a positive voltage level (e.g. +60kV), as shown in Figure 6. At this stage the thyristor valve 52 is turned on. When the current injection circuit 36 is injecting a current waveform 60 into the thyristor valve 52 under test, the controller 50 turns off each IGBT of each module of the voltage injection circuit 40 to allow the anti-parallel diodes to form a plurality of series-connected diode rectifiers with a combined internal voltage that is greater than a voltage across the fixed capacitor 54 so as to block current from flowing in each module and thereby inhibit current from flowing in the voltage injection circuit 40. The combined internal voltage is provided by the capacitors of the modules.

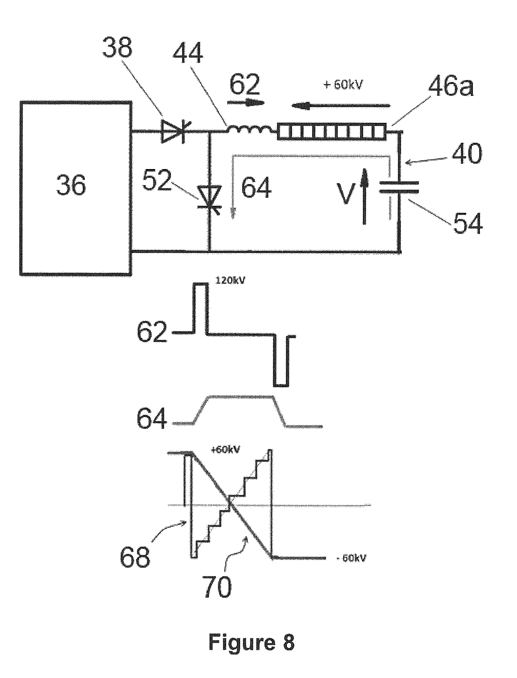

Towards the end of the injection of the current waveform 60 into the thyristor valve 52 under test, the controller 50 operates the current injection circuit 36 to reduce the amount of current it injects into the thyristor valve 52 under test to zero. The isolation switch 38 is then opened. The thyristor valve 52 under test remains in conduction, and the controller 50 operates each module of the voltage injection circuit 40 to selectively bypass each corresponding capacitor and insert each corresponding capacitor into the chain-link converter so as to generate a positive voltage across the chain-link converter that combines with the positive voltage across the fixed capacitor 54 to permit current to flow in the voltage injection circuit 40, as shown in Figure 8. This results in the combined voltage 62 being imposed across the inductor 44 of the voltage injection circuit 40. During the period in which current flows through the voltage injection circuit 40, the voltage injection circuit 40 injects a current waveform 64 into the thyristor valve 52 under test, whereby the injected current waveform 64 adds to the thermal loading of the thyristor valve 52 under test and permits the voltage injection circuit 40 to control a turn-off rate of change of current 66 in the thyristor valve 52 under test.

The injected current waveform 64 also discharges the fixed capacitor 54 from its positive voltage level to a negative voltage level with a nominally equal voltage magnitude (e.g. +60kV to -60kV), as shown in Figure 8. Meanwhile the controller 50 operates each module of the voltage injection circuit 40 to selectively bypass each corresponding capacitor and insert each corresponding capacitor into the chain-link converter so as to vary 68 a voltage across the chain-link converter during discharging 70 of the fixed capacitor 54. This allows the voltage injection circuit 40 to provide dynamic control over the voltage across the voltage injection circuit 40 and therefore the injected current waveform 64, but also improves control over the discharge rate of the fixed capacitor 54.

After the fixed capacitor 54 has reached the aforementioned negative voltage level, the controller 50 operates each module of the voltage injection circuit 40 so as to generate a negative voltage across the chain-link converter that combines with the negative voltage across the fixed capacitor 54 to impose a negative voltage 62 across the corresponding inductor 44 and thereby reduce the injected current waveform 64 to zero.

When the thyristor valve 52 under test is turned off and stops conducting current, it becomes exposed to the negative turn-off recovery voltage transient 58. The properties of the recovery voltage transient 58 (rate of change of voltage, voltage over-shoot and magnitude) can be controlled through the rate of change of current in the inductor 44 of the voltage injection circuit 40, the negative voltage contributed by the fixed capacitor 54, and the negative voltage available from the chain-link converter of the voltage injection circuit 40.

Once the voltage injection circuit 40 has completed the injection of the initial portion 72 of the recovery voltage transient 58 (i.e. to the maximum point of the over-shoot), the remainder 74 of the recovery voltage transient 58 is applied by varying the voltage across the chain link converter (e.g. from -60kV to +60kV). This may be done in conjunction with the recharging of the fixed capacitor 54 by the power charging circuit 56 to return the fixed capacitor 54 to the starting positive voltage level (e.g. +kV), and so the resonant cycle can then be repeated.

The synthetic test circuit 30 is therefore capable of performing an electrical test in which:
- the current injection circuit 36 injects high current loading to the thyristor valve 52 under test;
- the voltage injection circuit 40 takes over the injection of the current waveform into the thyristor valve 52 under test to permit a relatively prolonged turn-off time (e.g. 300 µs) of the isolation switch 38;
- the voltage injection circuit 40 controls a turn-off rate of change of current in the thyristor valve 52 under test;
- the voltage injection circuit 40 applies a desired turn-off recovery voltage transient 58 to the thyristor valve 52 under test.

A simulation model for the synthetic test circuit 30 was carried out with a peak voltage of 120 kV applied across and a current of 3 kA flowing through the thyristor valve 52 under test.

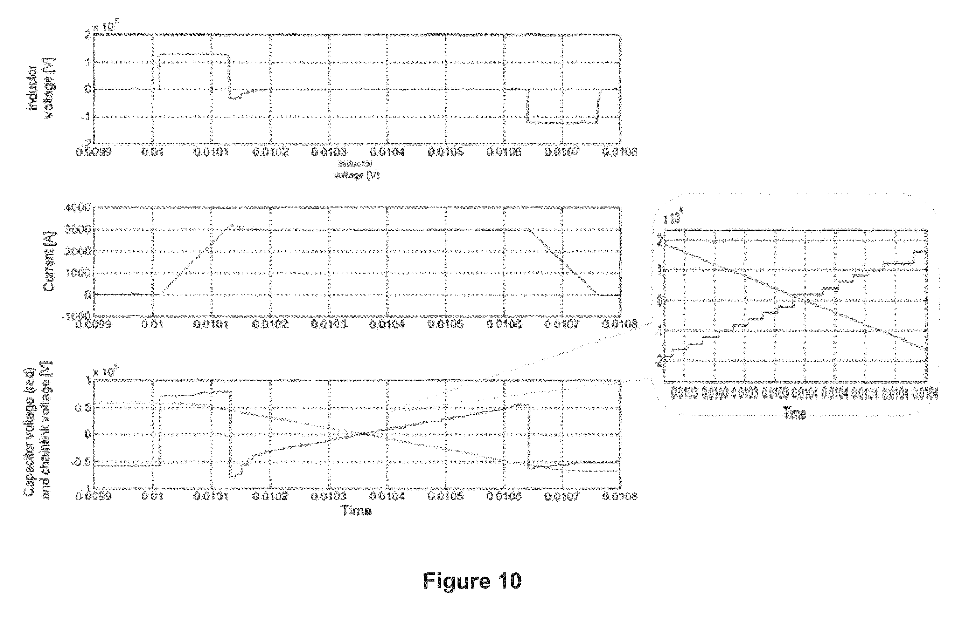

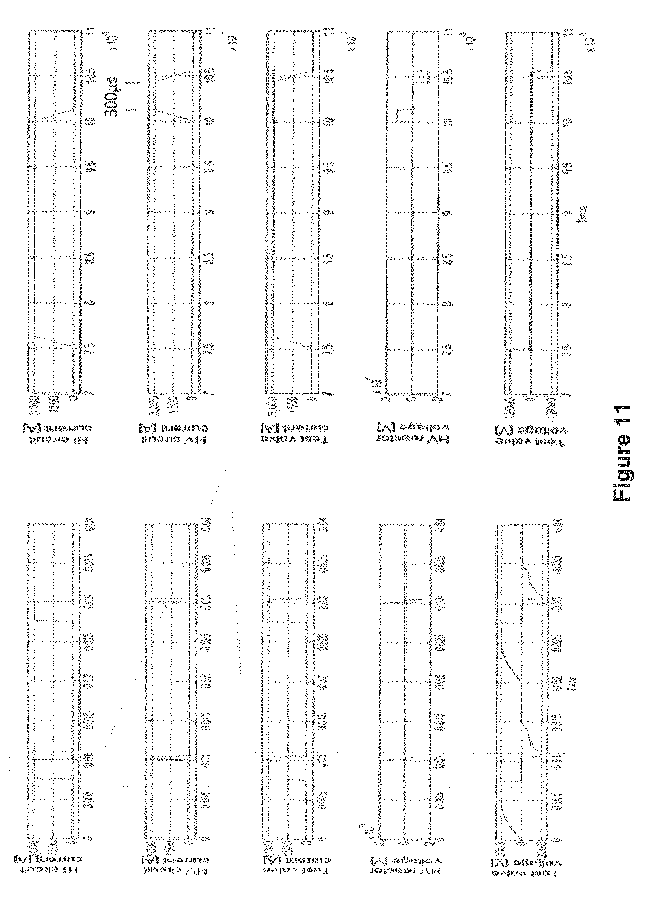

Figure 10 shows current and voltage waveforms of the voltage injection circuit 40 resulting from the simulation of the above-described operation of the synthetic test circuit 30 during one resonant cycle, while Figure 11 shows current and voltage waveforms of the current and voltage injection circuits 36,40 resulting from the simulation of the above-described operation of the synthetic test circuit 30 during repeated successive resonant cycles. It can be seen from Figures 10 and 11 that the resultant current and voltage waveforms from the simulation model for the synthetic test circuit 30 are in close agreement with the desired current and voltage waveforms associated with the synthetic test circuit 30 as shown in Figure 9.

In addition, in order to check whether the thyristor valve 52 compiles with certain testing requirements, the controller 50 may be configured to operate the voltage injection circuit 40 to inject a voltage waveform into the thyristor valve 52 under test to carry out an electrical test selected from a group including:
- application of a turn-on or turn-off rate of change of voltage to the thyristor valve 52;
- application of an off-state voltage stress to the thyristor valve 52;
- application of a turn-on voltage transient to the thyristor valve 52.

In view of the foregoing the provision of the chain-link converters in the current and voltage injection circuits 36,40 therefore results in a synthetic test circuit 30 that is not only capable of performing high quality electrical testing, but also has the flexibility to perform an electrical test on a broad range of thyristor valves 52 with different ratings. This is because the capability of the chain-link converter to generate a voltage waveform thereacross using a step-wise approximation allows the current and voltage injection circuits 36,40 to inject current and voltage waveforms of varying levels into the thyristor valve 52 under test, and thus renders the synthetic test circuit capable of electrically testing various thyristor valves 52 across a wide range of ratings.

In addition the modular arrangement of the chain-link converter means that the number of modules in the chain-link converter can be readily scaled up or down to modify the voltage capability of the chain-link converter to match the testing requirements of the thyristor valve 52 under test, without having to make significant changes to the overall design of the synthetic test circuit 30.

Furthermore the provision of the fixed capacitor 54 fixedly connected in circuit in the voltage injection circuit 40 therefore allows the fixed capacitor 54 to contribute to the injected voltage waveform without requiring any switching of the fixed capacitor 54 into and out of circuit with the voltage injection circuit 40, thus reducing the number of modules in the corresponding chain-link converter necessary to enable injection of a given voltage waveform into the thyristor valve 52 under test.

It is envisaged that, in other embodiments of the invention, the structure of each module in each chain-link converter may vary. For example, in the chain-link converter of the voltage injection circuit, each module may include a plurality of module switches connected in parallel with an energy storage device in a full-bridge arrangement to define a bipolar module that can provide negative, zero or positive voltages and can conduct current in only one direction.

## Claims

1. A synthetic test circuit, for performing an electrical test on a device under test, comprising:
a terminal connectable to the device under test;
a voltage injection circuit operably connected to the terminal, the voltage injection circuit including a first voltage source, the first voltage source including a chain-link converter, the chain-link converter including a plurality of modules, each module including at least one energy storage device; and
a controller being configured to operate each module of the voltage injection circuit to selectively bypass the or each corresponding energy storage device and insert the or each corresponding energy storage device into the chain-link converter so as to generate a voltage across the chain-link converter and thereby operate the voltage injection circuit to inject a voltage waveform into the device under test,
wherein the voltage injection circuit further includes a second voltage source, the second voltage source being or including a capacitive energy storage device, the capacitive energy storage device being fixedly connected in circuit in the voltage injection circuit.

2. A synthetic test circuit according to Claim 1 wherein the second voltage source is fixedly connected in series with the chain-link converter of the voltage injection circuit.

3. A synthetic test circuit according to any preceding claim wherein each module includes at least one module switch, and the controller is configured to control switching of the or each module switch of each module of the voltage injection circuit so as to block current from flowing in each module and thereby inhibit current from flowing in the voltage injection circuit.

4. A synthetic test circuit according to Claim 3 wherein the or each module switch of each module includes an active switching device connected in parallel with an anti-parallel passive current check element, and the controller is configured to turn off the or each active switching device of each module of the voltage injection circuit to allow the anti-parallel passive current check elements to form a plurality of series-connected passive current check element rectifiers with a combined internal voltage that is greater than a voltage across the second voltage source so as to block current from flowing in each module and thereby inhibit current from flowing in the voltage injection circuit, wherein the combined internal voltage is provided by the energy storage devices of the modules.

5. A synthetic test circuit according to any preceding claim wherein the controller is configured to operate each module of the voltage injection circuit to selectively bypass the or each corresponding energy storage device and insert the or each corresponding energy storage device into the chain-link converter so as to vary a voltage across the chain-link converter during discharging of the capacitive energy storage device of the second voltage source.

6. A synthetic test circuit according to any preceding claim wherein the first voltage source is a bidirectional voltage source and/or the second voltage source is a bidirectional voltage source.

7. A synthetic test circuit according to any preceding claim wherein each module includes a plurality of module switches connected with the or each energy storage device to define a bipolar module that can provide negative, zero or positive voltages, optionally wherein each module includes a plurality of module switches connected in parallel with an energy storage device in a full-bridge arrangement to define a bipolar module that can provide negative, zero or positive voltages.

8. A synthetic test circuit according to Claim 7 wherein each module includes a plurality of module switches connected in parallel with an energy storage device in a full-bridge arrangement to define:
a 4-quadrant bipolar module that can provide negative, zero or positive voltages and can conduct current in two directions; or
a bipolar module that can provide negative, zero or positive voltages and can conduct current in only one direction.

9. A synthetic test circuit according to any preceding claim wherein the synthetic test circuit is rated for performing an electrical test on a switching element, the switching element being preferably a thyristor valve, the switching element being further preferably a thyristor valve for use in high voltage direct current (HVDC) power transmission.

10. A synthetic test circuit according to Claim 9 wherein the controller is configured to operate each module of the voltage injection circuit to selectively bypass the or each corresponding energy storage device and insert the or each corresponding energy storage device into the chain-link converter so as to generate a voltage across the chain-link converter and thereby inject a current waveform into the switching element so as to control a turn-off rate of change of current in the switching element.

11. A synthetic test circuit according to Claim 9 or Claim 10 wherein the controller is configured to operate the voltage injection circuit to inject a voltage waveform into the switching element to carry out an electrical test selected from a group including:
• application of a turn-off recovery voltage transient and/or overshoot to the switching element;
• application of a turn-on or turn-off rate of change of voltage to the switching element;
• application of an off-state voltage stress to the switching element;
• application of a turn-on voltage transient to the switching element.

12. A synthetic test circuit according to any preceding claim further including a current injection circuit operably connected to the terminal, the current injection circuit including a current source, the current source including a chain-link converter, the chain-link converter including a plurality of modules, each module including at least one energy storage device,
wherein the controller is configured to operate each module of the current injection circuit to selectively bypass the or each corresponding energy storage device and insert the or each corresponding energy storage device into the chain-link converter so as to generate a voltage across the chain-link converter and thereby operate the current injection circuit to inject a current waveform into the device under test.

13. A synthetic test circuit according to any preceding claim wherein the voltage injection circuit includes an inductor operatively connected to the first and second voltage sources.

14. A synthetic test circuit according to Claim 13 when dependent from Claim 10 wherein the controller is configured to operate each module of the voltage injection circuit to selectively bypass the or each corresponding energy storage device and insert the or each corresponding energy storage device into the chain-link converter so as to generate a voltage across the chain-link converter and thereby apply a voltage across the inductor in order to control the current waveform injected into the switching element so as to control a turn-off rate of change of current in the switching element.
